# EUROPEAN PATENT APPLICATION

(11) **EP 2 555 238 A1**
(43) Date of publication of application: **06.02.2013**
(21) Application number: 10848956.8
(22) Date of filing: 31.03.2010
(51) Int. Cl.: H01L 25/065, H01L 25/07, H01L 25/10, H01L 25/11, H01L 25/18, H05K 1/02

(54) **MULTICHIP MODULE, PRINTED WIRING BOARD UNIT, METHOD FOR MANUFACTURING MULTICHIP MODULE, AND METHOD FOR MANUFACTURING PRINTED WIRING BOARD UNIT**

(71) Applicant: Fujitsu Limited, Kawasaki-shi, Kanagawa 211-8588 (JP)
(72) Inventor: FUKUZONO, Kenji, Kanagawa 211-8588 (JP)
(74) Representative: Lewin, David Nicholas
(86) International application number: PCT/JP2010/055947
(87) International publication number: WO 2011/121779

(57) **Abstract**

A multichip module includes an arithmetic element that is a semiconductor element that executes arithmetic processing and a memory element that is arranged opposite the arithmetic element and that is a semiconductor element that stores therein data. Then, the multichip module includes the arithmetic element mounted thereon and includes a package board that includes, on a surface on which the arithmetic element is mounted, an external terminal that connects another part. Furthermore, the multichip module includes a reinforcing part on a surface at the opposite side from the surface of the package board on which the external terminal and that is arranged such that the reinforcing part covers an area from outside the peripheral portion of the arithmetic element to a predetermined position located on the central side of the package board.

## Description

### Technical Field

The embodiments discussed herein are directed to a multichip module, a printed wiring board, a method for manufacturing the multichip module, and a method for manufacturing the printed wiring board.

### Background Art

In recent years, the size of arithmetic elements, such as central processing units (CPUs), has increased as the size of parts has become smaller and as many-core architecture has come into use. For package boards having mounted thereon such arithmetic elements, a micro wiring technology has been developed. Furthermore, System In Package (SiP) has become widely used in order to aggregate functions, such as memories; therefore, multiple parts are need to be packaged as a single package. Accordingly, high-density packaging is further developed in a technology for packaging the package boards.

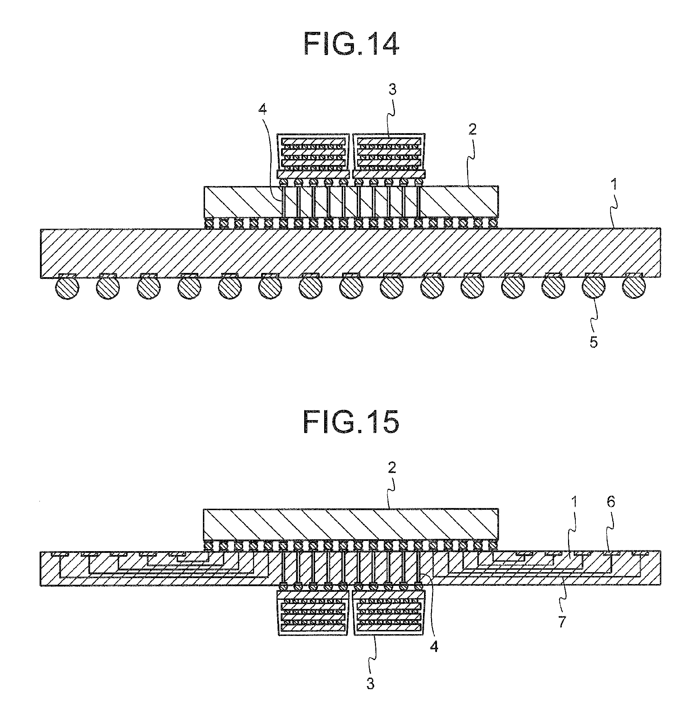

Currently, three-dimensional packages are coming into use in which through-silicon vias are arranged and packaged, thus implementing the use of multiple parts, high-density packaging, multi-terminal connection, and the like. For example, a multichip module that includes a package board 1, a CPU 2, stacked memories 3, through electrodes 4, and a Ball Grid Array (BGA) 5 has been developed, as illustrated in FIG. 14. FIG. 14 is a schematic diagram illustrating an example of a multichip module that includes a package board having mounted thereon parts using three-dimensional packaging.

As illustrated in FIG. 14, the CPU 2 that is bonded using flip chip bonding so that it is mounted on the package board 1, which has a core layer. Furthermore, the BGA 5 is mounted on a surface at the opposite side from the surface of the package board 1 on which the CPU 2 is mounted, i.e., on the bottom of the package. Then, the stacked memories 3, which are joined by the through electrodes 4, are mounted on a surface at the opposite side from the surface of the package board 1 on which the CPU 2 is mounted, i.e., on the back surface of the CPU 2. Accordingly, the CPU 2 and the stacked memories 3 are connected to the electrodes passing through the CPU 2 via the package board 1.

The multichip module using such three-dimensional packaging is useful when a large number of connecting terminals are needed, e.g., when a large CPU, such as a multi-core CPU, is joined to a high-density bulk memory. However, as illustrated in FIG. 14, when the stacked memories 3 are mounted on the CPU 2, with the back surface of the stacked memories 3 facing the CPU 2 in which the through electrodes 4 are arranged in the CPU 2, the back surface of the CPU 2 is covered by the stacked memories 3. Accordingly, the heat generated from the CPU 2 needs to be released via the stacked memories 3, and thus cooling efficiency is low.

As an example of three-dimensional packaging that improves cooling efficiency, a multichip module is disclosed that includes the package board 1, the CPU 2, the stacked memories 3, the through electrodes 4, external terminals 6, and wires 7, as illustrated in FIG. 15. FIG. 15 is a schematic diagram illustrating an example of a multichip module in which the cooling efficiency is improved. As illustrated in FIG. 15, the CPU 2 is joined to the stacked memories 3 by the through electrodes 4 such that the CPU 2 and the stacked memories 3 are opposed to each other across the package board 1 that has a core layer. Furthermore, the external terminals 6 arranged on the front surface of the package are connected to the CPU 2 via the wires 7. With such a multichip module illustrated in FIG. 15, because the stacked memories 3 are not arranged on the back surface of the CPU 2, the effect of the heat generated from the CPU 2 exerted on the stacked memories 3 is small and the effect of the heat generated from the stacked memories 3 exerted on the CPU 2 is also small. Accordingly, cooling efficiency is better in the multichip module illustrated in FIG. 15 than in the multichip module illustrated in FIG. 14.

### Citation List

### Patent Literature

Patent Literature 1: Japanese Laid-open Patent Publication No. 09-321184
Patent Literature 2: Japanese Laid-open Patent Publication No. 2001-308258

### Summary of invention

### Technical Problem

However, with the multichip module according to the conventional technology illustrated in FIG. 15, because a thin and high-density board needs to be used as a package board, there is a problem in that it is difficult to maintain the flatness.

Specifically, with the multichip module illustrated in FIG. 15, there is a need to use a high-density package board in which the through electrodes 4 have a fine pitch such that the distance between the CPU 2 and the stacked memories 3 is not large. However, in general, high-density package boards have a core layer. Accordingly, it is not easy to arrange the through electrodes 4, which pass through the core layer of the high-density package board and which have a fine pitch. Accordingly, to form the multichip module illustrated in FIG. 15, a thin and high-density package board that does not have a core layer is needed. If the thin high-density package board that does not have a core layer is used for the package illustrated in FIG. 15, because the board is thin, the effect of pressure externally applied is easily received and the shape of the board is deformed, and thus the flatness of the board is not maintained. In other words, the multichip module illustrated in FIG. 15 is not useful because the packaging efficiency is poor.

In contrast, with the multichip module illustrated in FIG. 14, it is possible to use a thick package board when compared with a case in which the board illustrated in FIG. 15 is used. Accordingly, the flatness of the board is easily maintained; however, as described above, the cooling efficiency is poor. Specifically, with the multichip module illustrated in FIG. 14, because a thick board having a core is used, the flatness of the board is easily maintained; however, the cooling efficiency is poor, whereas, with the multichip module illustrated in FIG. 15, the cooling efficiency is better; however, the flatness is not maintained.

Accordingly, the present invention has been conceived in light of the circumstances described above, and an object thereof is to provide a multichip module, a printed wiring board, a method for manufacturing the multichip module, and a method for manufacturing the printed wiring board that can maintain the flatness of the board and have high cooling efficiency.

### Solution to Problem

According to an aspect of the embodiment of the invention, a multichip module includes: an arithmetic element that is a semiconductor element that executes arithmetic processing; a memory element that is arranged opposite the arithmetic element, that is connected to the arithmetic element, and that is a semiconductor element that stores therein data; a package board that includes the arithmetic element mounted on the package board and that includes an external terminal that is on a surface on which the arithmetic element is mounted and that is connected to other parts; and a reinforcing part that is arranged on a surface at the opposite side from the surface of the package board that includes the external terminal and that is arranged such that the reinforcing part covers an area from outside the peripheral portion of the arithmetic element to a predetermined position located on the central side of the package board.

### Advantageous Effects of Invention

According to an aspect of an embodiment, with the multichip module, the printed wiring board, the method for manufacturing multichip module, and the method for manufacturing the printed wiring board according to the present invention, an advantage is provided in that the flatness of a board can be maintained and the cooling efficiency is high.

### Brief Description of Drawings

FIG. 1 is a sectional view illustrating, viewed from the side, a multichip module according to a first embodiment. FIG. 2 is a sectional view illustrating, viewed from above, the multichip module according to the first embodiment.
FIG. 3 is a sectional view illustrating, viewed from below, the multichip module according to the first embodiment.
FIG. 4 is a sectional view illustrating, viewed from the side, the multichip module in which a CPU and stacked memories face each other and are directly connected.
FIG. 5A is a sectional view illustrating, viewed from the side, a multichip module during manufacturing.
FIG. 5B is a sectional view illustrating, viewed from the side, a multichip module during manufacturing.
FIG. 5C is a sectional view illustrating, viewed from the side, a multichip module during manufacturing.
FIG. 5D is a sectional view illustrating, viewed from the side, a multichip module during manufacturing.
FIG. 5E is a sectional view illustrating, viewed from the side, a multichip module during manufacturing.
FIG. 5F is a sectional view illustrating, viewed from the side, a multichip module during manufacturing.
FIG. 6 is a schematic diagram illustrating an example of the cooling structure of a printed wiring board that includes the multichip module described in the first embodiment.
FIG. 7 is a schematic diagram illustrating an example of the cooling structure of a printed wiring board that includes the multichip module described in the first embodiment.
FIG. 8 is a schematic diagram illustrating an example of the cooling structure of a printed wiring board that includes the multichip module described in the first embodiment.
FIG. 9 is a schematic diagram illustrating an example of the cooling structure of a printed wiring board that includes the multichip module described in the first embodiment.
FIG. 10 is a schematic diagram illustrating an example of the cooling structure of a printed wiring board that includes the multichip module described in the first embodiment.
FIG. 11 is a schematic diagram illustrating the configuration of a multichip module that is used in an experiment.
FIG. 12 is a schematic diagram illustrating an example of results of experiments on the warpage of a package board.
FIG. 13 is a sectional view illustrating, viewed from the side, a multichip module in which a stiffener is mounted on only the center portion of the CPU.
FIG. 14 is a schematic diagram illustrating an example of a multichip module that includes a package board having mounted thereon parts using three-dimensional packaging.
FIG. 15 is a schematic diagram illustrating an example of a multichip module in which the cooling efficiency is improved.

### Embodiments for Carrying Out the Invention

Preferred embodiments of a multichip module, a printed wiring board, a method for manufacturing the multichip module, and a method for manufacturing the printed wiring board according to the present invention will be described in detail below with reference to the accompanying drawings. The present invention is not limited to the embodiments.

### [a] First Embodiment

### (Side view)

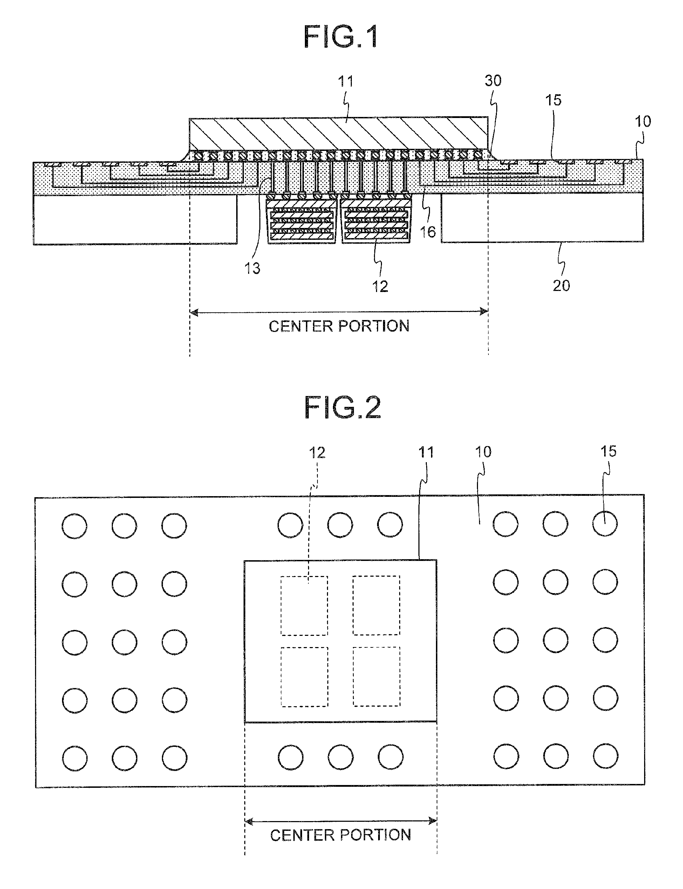

FIG. 1 is a sectional view illustrating, viewed from the side, a multichip module according to a first embodiment. The multichip module illustrated in FIG. 1 is formed with the inclusion of a package board 10, a CPU 11, stacked memories 12, through electrodes 13, external terminals 15, and a stiffener 20.

The package board 10 is a thin and high-density board that does not have a core; having has mounted thereon the CPU 11, which is an arithmetic element; includes the external terminals 15, which are connected to other parts; and has the CPU 11 mounted on its surface. In other words, the package board 10 is electrically connected to the CPU 11 and includes the external terminals 15 on the surface to which the CPU 11 is connected. Furthermore, the package board 10 includes therein wires 16 that connect the CPU 11 and the external terminals 15.

The CPU 11 is a semiconductor element that executes arithmetic processing. The CPU 11 is electrically connected to the stacked memories 12 via the through electrodes 13 that pass through the package board 10 such that the CPU 11 and the stacked memories 12 sandwich the package board 10 near the center portion of the package board 10. The CPU 11 is connected to the surface of the package board 10 on which the external terminals 15 are arranged. Furthermore, an underfill agent 30 that is a sealing resin fills the space between the CPU 11 and the package board 10. Furthermore, the CPU 11 is connected to the external terminals 15 included in the package board 10 by the wires 16.

The stacked memories 12 are semiconductor elements that store therein data; are arranged opposite the CPU 11 at the center portion of the CPU 11; and are connected thereto. The stacked memories 12 are electrically connected to the CPU 11 via the through electrodes 13 that pass through the package board 10 and the stacked memories 12 and the CPU 11 sandwich the package board 10 therebetween. Specifically, the stacked memories 12 are arranged opposite the CPU 11 at the center of the CPU 11 on a surface at the opposite side from the surface of the package board 10 on which the external terminals 15 are included, i.e., on a surface at the opposite side from the surface of the package board 10 on which the CPU 11 is mounted and the stacked memories 12 are electrically connected to the CPU 11.

The through electrodes 13 are used in one of the semiconductor packaging technology using electronic components and are electrodes perpendicularly passing through the inside of the package board 10. The through electrodes 13 connect to vertically arranged chips or elements, which have been connected using wire bonding in a conventional technology. In this example, the through electrodes 13 are arranged on the package board 10 with a fine pitch; pass through the package board 10; and electrically connect the CPU 11 and the stacked memories 12.

The external terminals 15 are terminals that electrically connect the CPU 11 and another electronic component or the like. Examples of the external terminals 15 include solder balls, lead wires, and electrode pads. The external terminals 15 are formed by being embedded into the surface of the package board 10 on which the CPU 11 is arranged.

The stiffener 20 is a reinforcing part that prevents the stainless steel or the copper from warping and that is arranged on a surface at the opposite side from the surface of the package board 10 on which the external terminals 15 are included and covers from the peripheral portion of the CPU 11 to a predetermined position on the central side. The stiffener 20 is bonded, using a heat resistant epoxy resin adhesive or the like, to the surface of the package board 10 on which the external terminals 15 are not arranged, i.e., on the surface of the package board 10 to which the stacked memories 12 are connected. Then, the stiffener 20 is arranged to cover the surface from the end (edge) of the package board 10 to the vicinity of the stacked memories 12.

### (Top view)

In the following, the diagram of the multichip module that is illustrated in FIG. 1 and that is viewed from above, i.e., viewed from the side on which the CPU 11 is mounted, will be described with reference to FIG. 2. FIG. 2 is a sectional view illustrating, viewed from above, the multichip module according to the first embodiment.

As illustrated in FIG. 2, when the multichip module illustrated in FIG. 1 is viewed from above, the CPU 11 and the external terminals 15 are formed on the front surface of the package board 10. The number of the external terminals 15 and the arrangement example of described here are only examples; therefore, they are not limited thereto. Furthermore, when the multichip module is viewed from above, the stacked memories 12 are not represented on the surface of the package board 10 because the CPU 11 is connected to the stacked memories 12 by being arranged opposite the stacked memories 12. In FIG. 2, four stacked memories 12 are illustrated; however the number of stacked memories 12 is not limited thereto.

### (Bottom view)

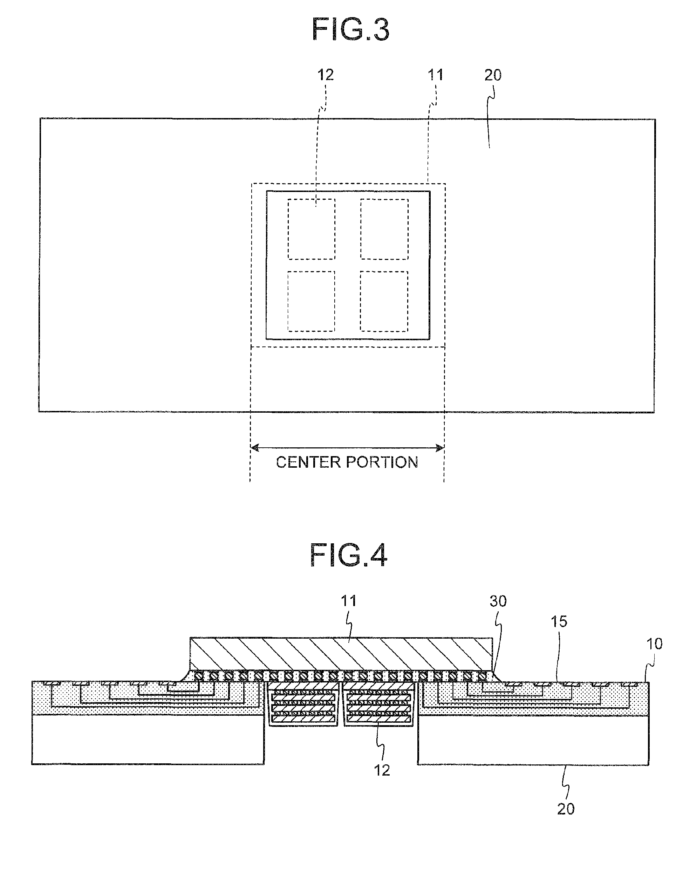

In the following, the diagram of the multichip module that is illustrated in FIG. 1 and that is viewed from below, i.e., viewed from the side on which the stacked memories 12 are mounted, will be described with reference to FIG. 3. FIG. 3 is a sectional view illustrating, viewed from below, the multichip module according to the first embodiment.

As illustrated in FIG. 3, when the multichip module illustrated in FIG. 1 is viewed from below, the stiffener 20 is arranged to cover the package board 10, from all of the edges, i.e., the left, right, top and bottom of the edges, to a predetermined position at the center portion in which the CPU 11 is mounted. Then, the stacked memories 12 are mounted at the center portion of the CPU 11. In FIG. 3, four stacked memories 12 are illustrated; however, similarly to FIG. 2, the number of stacked memories 12 is not limited thereto.

### (Advantage of the first embodiment)

According to the first embodiment, because the back surface of the CPU 11 does not need to be covered by the stacked memories 12, the effect of the heat generated from the CPU 11 exerted on the stacked memories 12 is small and the effect of the heat generated from the stacked memories 12 exerted on the CPU 11 is also small. Accordingly, with the multichip module formed in this way, the cooling efficiency is high. Furthermore, because the stiffener 20 is arranged on the bottom surface of the package board 10, even when a thin and high-density package board that does not have a core is used, it is possible to prevent deformation of the board due to the pressure externally applied. Accordingly, the multichip module formed in this way can maintain its flatness.

Furthermore, according to the first embodiment, it is possible to manufacture a package in which the CPU 11 and the stacked memories 12 are connected over a short distance, the CPU 11 is cooled from the back surface, warpage is small even if a thin wiring board is used, and the stress applied to the CPU 11 is small; therefore, it is possible to use the package in a test in which an external force is applied.

### [b] Second Embodiment

In the first embodiment, a description has been given of a case in which the CPU 11 and the stacked memories 12 are connected to the through electrodes 13 that pass through the package board 10; however, the present invention is not limited thereto. For example, the CPU 11 and the stacked memories 12 may also be directly and electrically connected without sandwiching the package board 10.

Accordingly, in a second embodiment, an example of a multichip module in which a CPU and stacked memories are directly connected by having them oppose each other will be described with reference to FIG. 4. FIG. 4 is a sectional view illustrating, viewed from the side, the multichip module in which a CPU and stacked memories face each other and are directly connected.

Similarly to the first embodiment, the multichip module illustrated in FIG. 4 is formed with the inclusion of the package board 10, the CPU 11, the stacked memories 12, the external terminals 15, and the stiffener 20. Specifically, the package board 10 has mounted thereon the CPU 11 and includes the external terminals 15, which are connected to other parts, on the surface on which the CPU 11 is mounted. Furthermore, similarly to the first embodiment, the stiffener 20 is arranged on a surface at the opposite side from the surface of the package board 10 on which the external terminals 15 are included and covers from the peripheral portion of the CPU 11 to a predetermined position on the central side.

The second embodiment differs from the first embodiment in that, on the package board 10, a portion in which the CPU 11 and the stacked memories 12 are connected, i.e., a center portion of the CPU 11, is empty and thus a space for mounting the stacked memories 12 is made available. Specifically, the second embodiment differs from the first embodiment in that the package board 10 is not arranged between the CPU 11 and the stacked memories 12. Accordingly, the CPU 11 and the stacked memories 12 are directly and electrically connected via, for example connecting terminals, without using the through electrodes 13.

By doing so, the CPU 11 and the stacked memories 12 can be connected over the minimum distance. Furthermore, even if the CPU 11 and the stacked memories 12 are connected over the minimum distance, there is no need to cover some of the surface of the CPU 11 by the stacked memories 12; therefore, the cooling efficiency is high. Furthermore, a thin and high-density package board can be used and the flatness can be maintained. Furthermore, it is possible to use a wiring board that does not need through electrodes, thus reducing the cost.

### [c] Third Embodiment

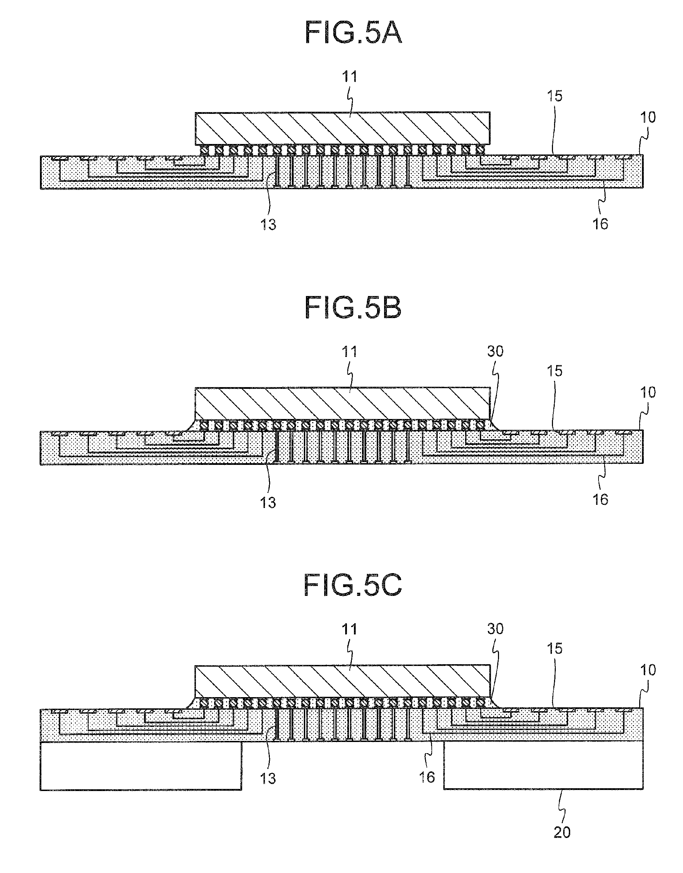

In the following, a manufacturing process of the multichip module described in the first embodiment will be described with reference to FIGS. 5A to 5F. The manufacturing process of the multichip module described in the third embodiment is performed by a predetermined manufacturing apparatus or is manually performed; however, in the following, a description will be given of a case in which manufacturing process is performed by a manufacturing apparatus. FIGS. 5A to 5F are sectional views each illustrating, viewed from the side, a multichip module during manufacturing.

As illustrated in FIG. 5A, the manufacturing apparatus joins, by soldering or the like, the CPU 11 to the surface of the thin and high-density package board 10 on which the external terminals 15 are mounted and a part of which the through electrodes 13 are arranged in a concentrated manner. By doing so, the CPU 11 and the external terminals 15 are connected by the wires 16 inside the package board 10.

Subsequently, as illustrated in FIG. 5B, the manufacturing apparatus fills the underfill agent 30 into the joining portion between the package board 10 having mounted thereon the CPU 11 and the CPU 11. Accordingly, the joining between the package board 10 and the CPU 11 is strengthened and sealed.

Then, as illustrated in FIG. 5C, the manufacturing apparatus mounts the stiffener 20 on a surface at the opposite side from the surface of the package board 10 on which the CPU 11 is mounted and in which the external terminals 15 are included such that the stiffener 20 covers the package board 10 from the peripheral portion of the CPU 11 to a predetermined position on the central side. Specifically, the manufacturing apparatus mounts the stiffener 20 to cover the surface of the package board 10 from the edge thereof to the vicinity of the stacked memories 12. At this time, the manufacturing apparatus bonds the surface of the package board 10 to the stiffener 20 with, for example, a heat-resistant epoxy resin adhesive.

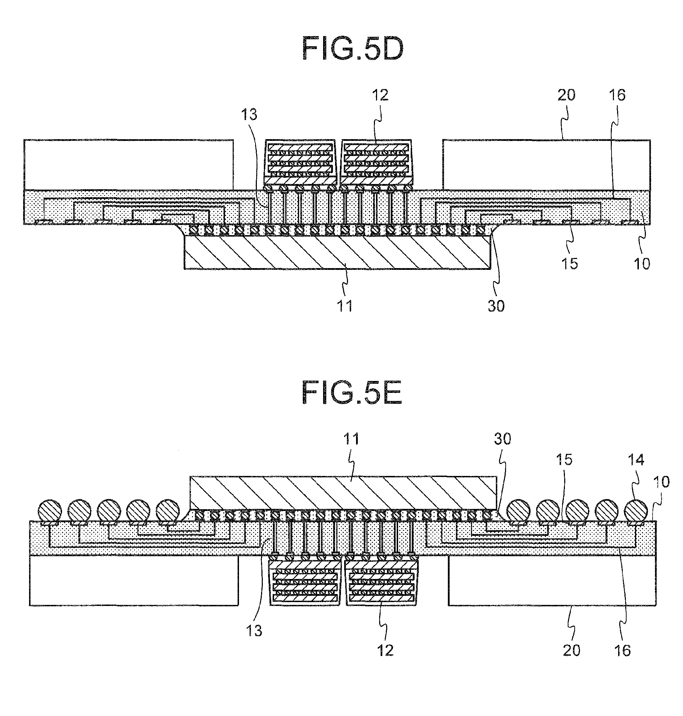

Subsequently, as illustrated in FIG. 5D, the manufacturing apparatus joins, by soldering or the like, the stacked memories 12 to the CPU 11 such that they are opposed to each other across the package board 10 having mounted thereon the stiffener 20. Specifically, the manufacturing apparatus mounts the stacked memories 12 such that the stacked memories 12 are connected to the through electrodes 13 to which the CPU 11 is connected. More specifically, the manufacturing apparatus mounts the CPU 11 and the stacked memories 12 on different ends, respectively, of the through electrodes 13 that pass through the package board 10.

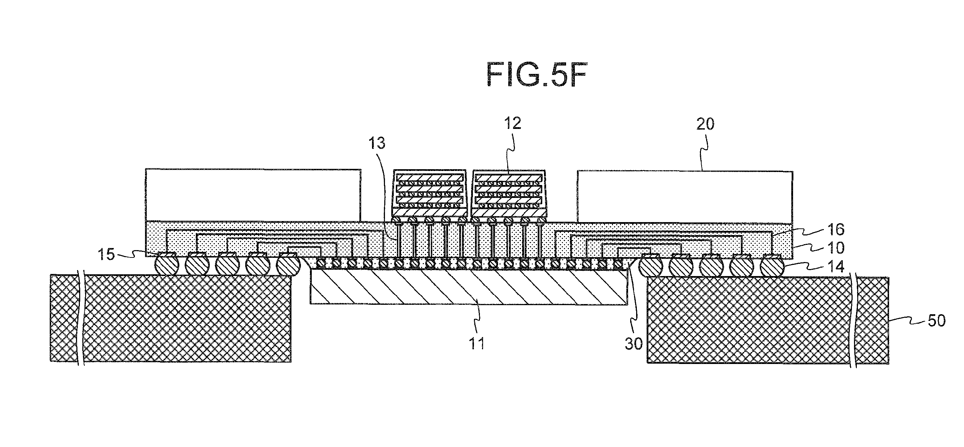

Then, as illustrated in FIG. 5E, the manufacturing apparatus mounts a predetermined BGA 14 on the external terminals 15 included in the package board 10, which has mounted thereon the CPU 11, the stiffener 20, and the stacked memories 12. Then, as illustrated in FIG. 5F, the manufacturing apparatus connects a motherboard 50 to the BGA 14 that is mounted on the package board 10. Accordingly, it is possible to manufacture the multichip module described in the first embodiment and manufacture a printed wiring board that includes the multichip module.

### [d] Fourth Embodiment

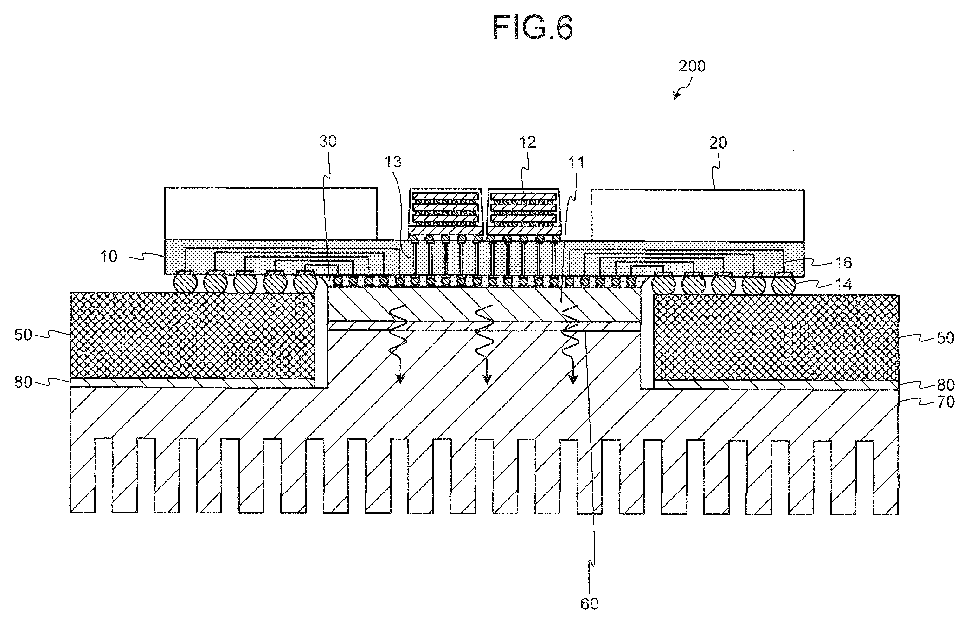

In the following, a description will be given of the cooling structure with reference to FIGS. 6 to 10, in which the multichip module described in the first embodiment is efficiently cooled in a state in which the multichip module is connected to the motherboard. FIGS. 6 to 10 are schematic diagrams illustrating an example of the cooling structure of a printed wiring board that includes the multichip module described in the first embodiment.

FIG. 6 illustrates the cooling structure of the printed wiring board illustrated in FIG. 5F. A printed wiring board 200 illustrated in FIG. 6 is the same as that created in FIGS. 5A to 5F; therefore, a description thereof in detail will be omitted here. FIG. 6 illustrates the cooling structure in which a heat sink is mounted on the printed wiring board 200 and the cooling is performed by radiating heat via the heat sink. In this example, the motherboard 50 of the printed wiring board 200 is bonded to a heat sink 70 using a heat resistant epoxy resin adhesive 80 or the like. Furthermore, a high thermal conductive sheet (TIM) 60 is mounted between the CPU 11 and the heat sink 70 on the printed wiring board 200. Accordingly, the heat generated from the CPU 11 reaches the heat sink 70 via the TIM 60 and is radiated via the heat sink 70. Accordingly, the cooling can be efficiently performed.

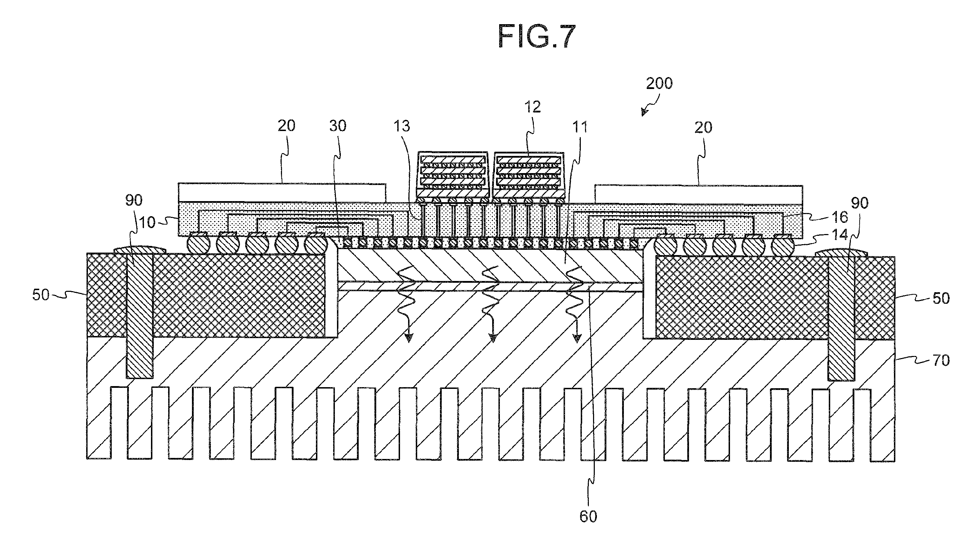

In the following, the printed wiring board 200 including the TIM 60 and the heat sink 70 illustrated in FIG. 7 has the same configuration as that illustrated in FIG. 6; however, the method for connecting the motherboard 50 of the printed wiring board 200 and the heat sink 70 differs from that illustrated in FIG. 6. In a case illustrated in FIG. 6, the motherboard 50 of the printed wiring board 200 is bonded to the heat sink 70 with the epoxy resin adhesive 80 or the like, whereas, in the case illustrated in FIG. 7, they are connected using pins 90 or the like. Accordingly, a gap between the printed wiring board 200 and the heat sink 70 can be eliminated, thus the cooling can be more efficiently performed. Furthermore, instead of using the pins 90, they can be joined using joining parts, such as screws.

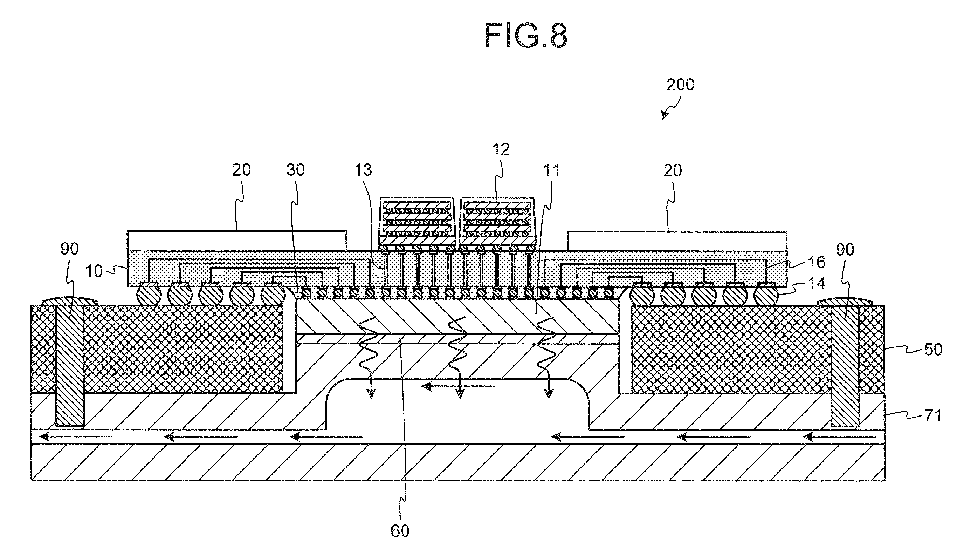

In FIG. 8, similarly to FIG. 7, the printed wiring board 200 and a heat sink 71 are connected using the pins 90. The case illustrated in FIG. 8 differs from that illustrated in FIG. 7 in that the heat sink 71 has a heat pipe therein. The heat sink 71 contains a volatile working fluid, such as alternative CFCs, in the heat pipe. Accordingly, the heat generated from the printed wiring board 200 can be cooled in the heat pipe; therefore, the cooling can be more efficiently performed. The heat pipe is used as an example contained in the heat sink 71; however, the configuration is not limited thereto. For example, a micro channel or a heat exchanger may also be used.

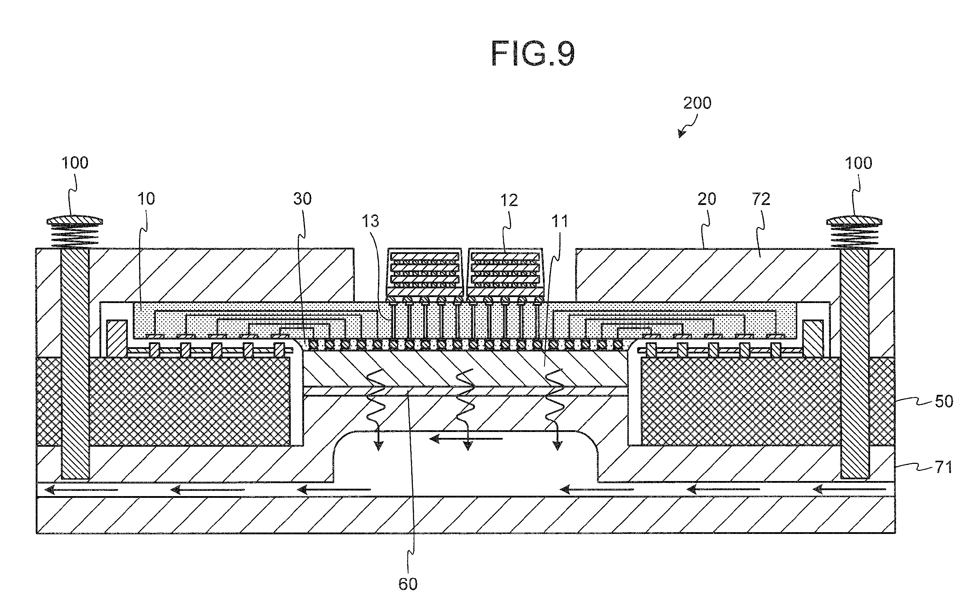

FIG. 9 illustrates an example in which the heat sink 71 that is the same as that illustrated in FIG. 8 is joined to the printed wiring board 200; however, the configuration illustrated in FIG. 9 differs from that illustrated in FIG. 8 in that a heat sink 72 is additionally mounted on the portion, in which the stiffener 20 illustrated in FIG. 8 is mounted, and is joined using the spring loading due to a spring 100. The heat sink 72 that is used instead of the stiffener 20 functions, similarly to the stiffener 20, as a reinforcing part that prevents the warpage and also functions as a radiator that radiates the heat from the package board 10. Furthermore, in FIG. 9, because the joining is performed using the spring loading, instead of the BGA 14 that is connected to the external terminals 15 in the package board 10, the motherboard 50 is held in press contact by a connector. Similarly to FIG. 8, the stiffener 20 may also be arranged in the example illustrated in FIG. 9. In such a case, the heat sink 72 illustrated in FIG. 9 may be arranged to cover the stiffener 20.

FIGS. 6 to 9 illustrate an example of a case in which the heat sink is created in accordance with the shape of the printed wiring board 200. Specifically, FIGS. 6 to 9 illustrate an example of a case in which a heat sink having a protruding portion is created on the printed wiring board 200 such that the heat sink can be brought into contact with both the motherboard 50 and the CPU 11. In the following, an example of the cooling structure in which efficient cooling can be implemented using something other than the heat sink will be described.

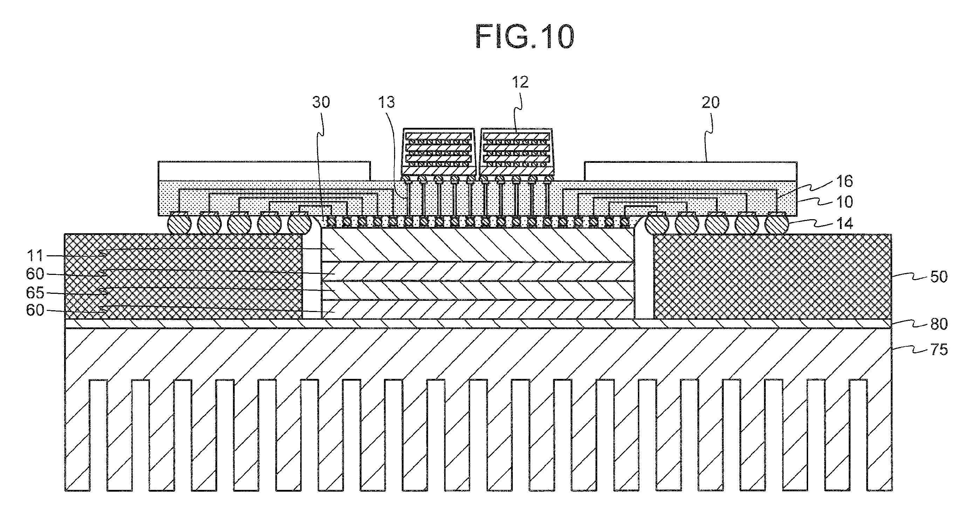

As illustrated in FIG. 10, a heat sink 75 can be brought into contact with the motherboard 50 but not be brought into contact with the CPU 11. In such a case, the CPU 11 and the heat sink 75 are connected via a heat spreader. Furthermore, to improve the cooling efficiency, the TIM 60 is arranged between the CPU 11 and a heat spreader 65 and the TIM 60 is also arranged between the heat sink 75 and the heat spreader 65. By doing so, the heat generated from the CPU 11 or the like easily flows to the heat spreader 65 and the heat sink 75, thus improving the cooling efficiency.

### [e] Fifth Embodiment

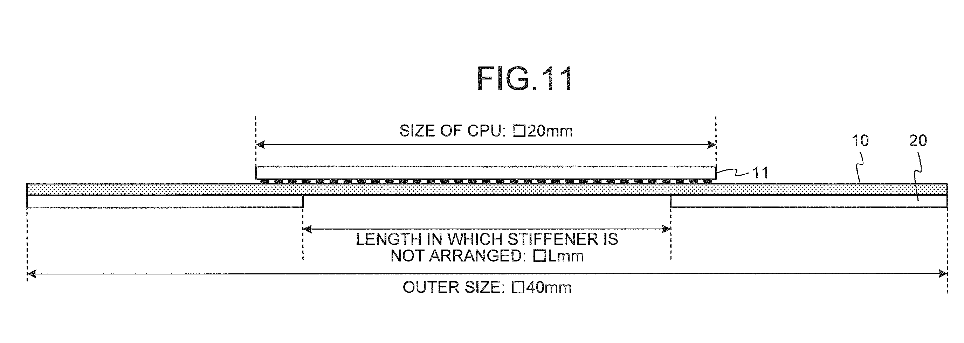

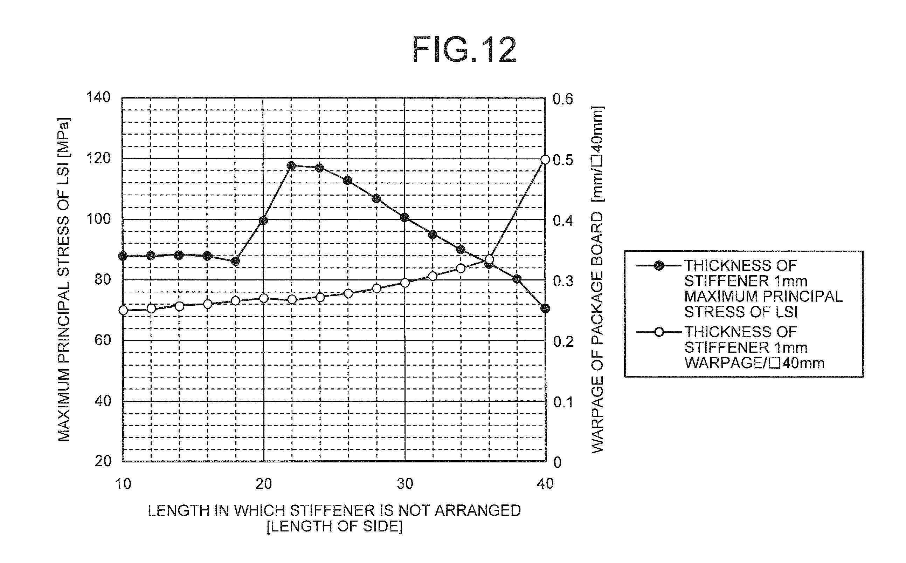

In the following, an example of an experiment into the usefulness of the stiffener 20 will be described with reference to FIGS. 11 and 12. FIG. 11 is a schematic diagram illustrating the configuration of a multichip module that is used in the experiment. As in the example illustrated in FIG. 11, a description will be given of a case in which the outer size of the package board is 40 mm, the size of the CPU is 20 mm, and the length in which the stiffener is not arranged is L mm. Furthermore, the thickness of the stiffener is 1 mm.

In this experiment, when the multichip module illustrated in FIG. 11 is packaged as an LSI, the warpage of the package board 10 with respect to a change in the maximum principal stress (MPa) of the LSI is measured by changing the position of the stiffener. The results of the experiments are illustrated in FIG. 12. FIG. 12 is a schematic diagram illustrating an example of results of experiments on the warpage of a package board. In the graph in FIG. 12, the horizontal axis indicates the length in which the stiffener is not arranged (the length of a side) is L mm. Furthermore, the left vertical axis indicates the maximum principal stress and the right vertical axis indicates the warpage (mm/40 mm) of the package board when the multichip module illustrated in FIG. 11 is packaged as an LSI.

As illustrated in FIG. 12, it can be seen that if the length in which a stiffener is not arranged is 40 mm, i.e., if a stiffener is not mounted, the warpage of the package board is 0.5 mm. Furthermore, if the length in which a stiffener is not arranged exceeds 20 mm, the maximum principal stress of the LSI sharply increases and the warpage of the package board also sharply increases. Specifically, when a stiffener is arranged only on the outside of the peripheral portion of the CPU (on the edge side of the package board), it is hard to tell whether the warpage of the package board can be prevented. However, the length in which a stiffener is not arranged is less than 20 mm, i.e., when a stiffener is arranged from the peripheral portion of the CPU to the center portion, it can be seen that the warpage of the package board can be prevented.

### [f] Sixth Embodiment

In the above explanation, a description has been given of the embodiments according to the present invention; however, the embodiments are not limited thereto and can be implemented with various kinds of embodiments other than the embodiments described above. Therefore, another embodiment will be described below.

### (Mounting position of the stiffener)

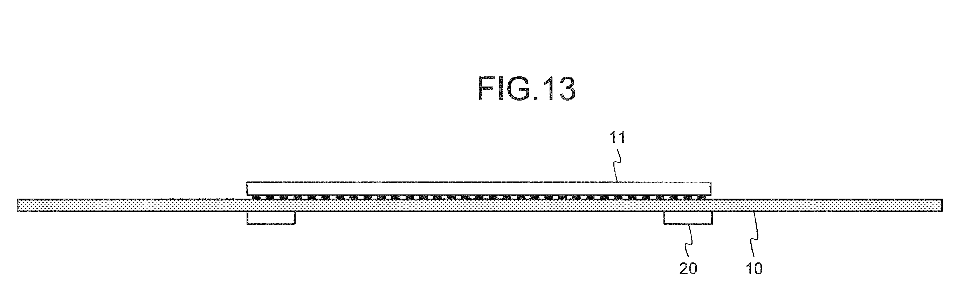

The stiffener in the multichip module disclosed in the present invention is not always mounted as described in the first or the second embodiments. For example, as illustrated in FIG. 13, a stiffener may also be mounted on only the center of the CPU. In other words, a stiffener is not mounted from the circumferential side of the CPU to the end of the package board. When mounting the stiffener in this way, the strength of the package board is low when compared with a case in the first or the second embodiment; therefore, the degree of prevention of the warpage is low. In other words, the warpage can be sufficiently prevented in the case in the first or the second embodiment. However, even when a stiffener is mounted as illustrated in FIG. 13, the warpage can be sufficiently prevented and cooling efficiency is high when compared with the conventional technology. FIG. 13 is a sectional view illustrating, viewed from the side, a multichip module in which a stiffener is mounted on only the center portion of the CPU.

### (Semiconductor element)

In the embodiments described above, a description has been given of a case in which the arithmetic element and the memory element are opposite each other and connected to each other; however, the configuration is not limited thereto. To implement an object, the technology disclosed in the present invention can be widely used for a large scale integrated (LSI), an interposer, a motherboard, a typical semiconductor element, a typical package board, a typical relay board, and a typical circuit board.

### Explanation of Reference

- 10: PACKAGE BOARD
- 11: CPU
- 12: STACKED MEMORY
- 13: THROUGH ELECTRODE
- 14: BGA
- 15: EXTERNAL TERMINAL
- 16: WIRE
- 20: STIFFENER
- 30: UNDERFILL AGENT
- 50: MOTHERBOARD
- 60: TIM
- 70, 71, 72, 75: HEAT SINK
- 80: EPOXY RESIN ADHESIVE
- 90: PIN
- 100: SPRING
- 200: PRINTED WIRING BOARD

## Claims

1. A multichip module comprising:
an arithmetic element that is a semiconductor element that executes arithmetic processing;
a memory element that is arranged opposite the arithmetic element, that is connected to the arithmetic element, and that is a semiconductor element that stores therein data;
a package board that includes the arithmetic element mounted on the package board and that includes an external terminal that is on a surface on which the arithmetic element is mounted and that is connected to other parts; and
a reinforcing part that is arranged on a surface at the opposite side from the surface of the package board that includes the external terminal and that is arranged such that the reinforcing part covers an area from outside the peripheral portion of the arithmetic element to a predetermined position located on the central side of the package board.

2. The multichip module according to claim 1, wherein the memory element and the arithmetic element sandwich the package board therebetween and are connected to the arithmetic element via a through electrode that pass through the package board.

3. The multichip module according to claim 1, wherein the memory element is directly connected to the arithmetic element without the package board being sandwiched between the memory element and the arithmetic element.

4. The multichip module according to claim 1, wherein the reinforcing part is arranged to cover an entire surface at the opposite side from the surface of the package board that includes the external terminal from a predetermined position at the center portion of the arithmetic element.

5. A printed wiring board comprising:
an arithmetic element that is a semiconductor element that executes arithmetic processing;
a memory element that is arranged opposite the arithmetic element, that is connected to the arithmetic element, and that is a semiconductor element that stores therein data;
a package board that includes the arithmetic element mounted on package board and that includes an external terminal that is on a surface on which the arithmetic element is mounted and that is connected to other parts;
a reinforcing part that is arranged on a surface at the opposite side from the surface of the package board that includes the external terminal and that is arranged such that the reinforcing part covers an area from outside the peripheral portion of the arithmetic element to a predetermined position located on the central side of the package board;
an electronic circuit board that is connected to the external terminal included in the package board; and
a heat radiating part that is joined to the arithmetic element on a surface at the opposite side from the surface of the electronic circuit board to which the package board is connected.

6. A method of manufacturing a multichip module causing a manufacturing apparatus that manufactures a multichip module to execute a process comprising:
joining an arithmetic element that is a semiconductor element that executes arithmetic processing, the joining of the arithmetic element being such that the arithmetic element is connected to through electrodes on a surface of a package board that includes an external terminal that is connected to other parts and that includes the through electrodes, which are concentrated in a part of the package board;
filling a sealing agent into a joining portion between the arithmetic element and the package board;
joining a reinforcing part to a surface at the opposite side from the package board on which the arithmetic element is joined, the joining of the reinforcing part being such that the reinforcing part covers an area from outside the peripheral portion of the arithmetic element to a predetermined position located on the central side of the package board; and
joining a memory element that is a semiconductor element that stores therein data, the joining of the memory element being such that the memory element is arranged opposite the arithmetic element so that the package board to which the arithmetic element is joined is sandwiched between the memory element and the arithmetic element, and the joining of the memory element being such that the reinforcing part on the package board is connected to the through electrodes.

7. A method of manufacturing a printed wiring board causing a manufacturing apparatus that manufactures a printed wiring board to execute a process comprising:
joining an arithmetic element that is a semiconductor element that executes arithmetic processing, the joining of the arithmetic element being such that the arithmetic element is connected to through electrodes on a surface of a package board that includes an external terminal that is connected to other parts and that includes the through electrodes, which are concentrated in a part of package board;
filling a sealing agent into a joining portion between the arithmetic element and the package board;
joining a reinforcing part to a surface at the opposite side from the package board on which the arithmetic element is joined, the joining of the reinforcing part being such that the reinforcing part covers an area from outside the peripheral portion of the arithmetic element to a predetermined position located on the central side of the package board;
joining a memory element that is semiconductor elements that stores therein data, the joining of the memory element being such that the memory element is arranged opposite the arithmetic element so that the package board to which the arithmetic element is joined is sandwiched between the memory element and the arithmetic element, and the joining of the memory element being such that the reinforcing part on the package board is connected to the through electrodes;
joining an electronic circuit board to the external terminal that is arranged on the package board in which the arithmetic element, the memory element, and the reinforcing part are joined; and
joining a heat radiating part such that the heat radiating part is brought into contact with both the electronic circuit board and the arithmetic element.
